# EUROPEAN PATENT APPLICATION

(11) **EP 4 460 170 A2**
(43) Date of publication of application: **06.11.2024**
(21) Application number: 24200020.6
(22) Date of filing: 12.09.2024
(51) Int. Cl.: H10K 59/122

(54) **STRETCHABLE DISPLAY PANEL AND DISPLAY DEVICE**

(30) Priority: 15.09.2023 CN 202311199578
(71) Applicant: Hefei Visionox Technology Co., Ltd., Hefei, Anhui 230000 (CN); Yungu (Gu'an) Technology Co., Ltd., Langfang, Hebei 065500 (CN)
(72) Inventor: JIANG, Danyang, Hefei, 230000 (CN); LIU, Yang, Hefei, 230000 (CN); LI, Jingjing, Hefei, 230000 (CN); ZHANG, Rong, Hefei, 230000 (CN); JIANG, Bo, Hefei, 230000 (CN)
(74) Representative: Kraus & Lederer PartGmbB

(57) **Abstract**

A stretchable display panel (100) includes a substrate (1) and a plurality of spaced pixel islands (2) disposed on the substrate (1). The pixel island (2) has a light-emitting area (2a) and a non-light-emitting area (2b) adjacent to the light-emitting area (2a). The pixel island (2) includes: a driving layer group (21) disposed on the substrate (2); a pixel-defining structure (22) disposed on the driving layer group (21), wherein the pixel-defining structure (22) defines a pixel opening located in the light-emitting area (2a), at least one groove (25) is located in the non-light-emitting area (2b) and disposed at a side of the pixel-defining structure (22) away from the driving layer group (21), and the groove (25) extends through the pixel-defining structure (22) and a part of the driving layer group (22) along a thickness direction of the substrate (1); a light-emitting unit (23) disposed in the pixel opening; and an encapsulating layer (24) covering a surface of the light-emitting unit (23) away from the substrate (1) and a surface of the groove (25).

## Description

### TECHNICAL FIELD

The present application relates to the field of display technology, in particular to a stretchable display panel and a display device.

### BACKGROUND

In recent years, stretchable organic light-emitting diode (OLED) display panels have attracted much attentions and developments in the display industry due to their unique display form. At present, existing stretchable OLED display panels can initially achieve a stretching rate of 10% but have relatively poor encapsulation reliability.

### SUMMARY

Based on the above, there is a need to provide a stretchable display panel with enhanced encapsulation reliability, and a display device.

In a first aspect, an embodiment of the present application provides a stretchable display panel. The stretchable display panel includes a substrate and a plurality of pixel islands disposed on the substrate. The plurality of pixel islands are spaced from each other. The pixel island has a light-emitting area and a non-light-emitting area adjacent to the light-emitting area. The pixel island includes a driving layer group, a pixel-defining structure, a light-emitting unit, and an encapsulating layer. The driving layer group is disposed on the substrate. The pixel-defining structure is disposed on the driving layer group. The pixel-defining structure defines a pixel opening located in the light-emitting area. At least one groove is located in the non-light-emitting area and at a side of the pixel-defining structure away from the driving layer group, extending through the pixel-defining structure and a part of the driving layer group along a thickness direction of the substrate. The light-emitting unit is disposed in the pixel opening. The encapsulating layer covers a surface of the light-emitting unit away from the substrate and a surface of the groove.

In the stretchable display panel described above, the groove is disposed in the pixel-defining structure and located in the non-light-emitting area, the groove extends through the pixel-defining structure and a part of the driving layer group, and the encapsulating layer extends to cover the surface of the groove. As such, on the one hand, the groove can mitigate the extending tendency of cracks toward the light-emitting area; on the other hand, the groove can increase a contact area of the encapsulating layer, enhancing the overall encapsulation reliability of the encapsulating layer, thereby increasing the service life of the stretchable display panel.

In a second aspect, an embodiment of the present application provides another stretchable display panel. The stretchable display panel includes a substrate and a plurality of pixel islands disposed on the substrate. The plurality of pixel islands are spaced from each other. The pixel island has a light-emitting area and a non-light-emitting area adjacent to the light-emitting area. The pixel island includes a driving layer group, a light-emitting unit, an encapsulation auxiliary structure, and an encapsulating layer. The driving layer group is disposed on the substrate. The light-emitting unit is disposed on the driving layer group and is located in the light-emitting area. The encapsulation auxiliary structure is disposed on the driving layer group and located in the non-light-emitting area. At least one slot is disposed at a side of the encapsulation auxiliary structure away from the driving layer group. The encapsulation auxiliary structure includes an inorganic material. The encapsulating layer covers a surface of the light-emitting unit away from the substrate and a surface of the slot.

In the stretchable display panel described above, the encapsulation auxiliary structure is disposed on the driving layer group, the slot is disposed in the encapsulation auxiliary structure, and the encapsulating layer extends to cover the surface of the slot. As such, on the one hand, the slot can mitigate the extending tendency of cracks toward the light-emitting area; on the other hand, the slot can increase a contact area of the encapsulating layer, improving the encapsulation performance of the encapsulating layer. Besides, the encapsulating layer is in direct contact with the slot defined by the inorganic material, improving the film adhesion of the encapsulating layer, which further improves the encapsulation performance of the encapsulating layer, thereby enhancing the overall encapsulation reliability of the encapsulating layer, and increasing the service life of the stretchable display panel.

In a third aspect, an embodiment of the present application provides yet another stretchable display panel. The stretchable display panel includes a substrate and a plurality of pixel islands disposed on the substrate. The plurality of pixel islands are spaced from each other. The pixel island includes a driving layer group, a light-emitting unit, at least one protective structure, and an encapsulating layer. The driving layer group is disposed on the substrate and includes a main body portion and an edge portion connected to the main body portion. The light-emitting unit is disposed on the main body portion. The protective structure is disposed on the edge portion and includes at least one concave portion. The encapsulating layer covers a surface of the light-emitting unit away from the substrate and a surface of the concave portion.

In the stretchable display panel described above, the protective structure is disposed on the edge portion and includes the concave portion, and the encapsulating layer extends to cover the surface of the concave portion. As such, on the one hand, the concave portion can mitigate the extending tendency of cracks toward the main body portion; on the other hand, the concave portion can increase a contact area of the encapsulating layer, enhancing the overall encapsulation reliability of the encapsulating layer, thereby increasing the service life of the stretchable display panel.

In a fourth aspect, an embodiment of the present application provides a display device including the stretchable display panel in any one of the embodiments of the first aspect, the second aspect, or the third aspect.

According to the display device described above, on the one hand, the extending tendency of cracks toward the light-emitting unit can be mitigated; on the other hand, a contact area of the encapsulating layer can be increased, enhancing the overall encapsulation reliability of the encapsulating layer, thereby increasing the service life of the stretchable display panel.

### BRIEF DESCRIPTION OF THE DRAWINGS

In order to clearly illustrate the technical solutions in the embodiments or examples of the present application, the drawings used in the description of the embodiments or examples will be described briefly below. Apparently, the following described drawings are merely for some embodiments of the present application, and other drawings can be derived based on these drawings by those of ordinary skill in the art without any creative effort.
FIG. 1 is a partial top view of a display panel provided in an embodiment of the present application.
FIG. 2 is a schematic cross-sectional structural view of the display panel shown in FIG. 1.
FIG. 3 is a schematic view of a layout of grooves of the display panel shown in FIG. 1.
FIG. 4 is a schematic view of another layout of the grooves of the display panel shown in FIG. 1.
FIG. 5 is a schematic view of yet another layout of the grooves of the display panel shown in FIG. 1.
FIG. 6 is a schematic view of yet another layout of the grooves of the display panel shown in FIG. 1.
FIG. 7 is a schematic view of a layout of protective structures of the display panel shown in FIG. 1.
FIG. 8 is a schematic view of another layout of the protective structures of the display panel shown in FIG. 1.
FIG. 9 is a schematic cross-sectional structural view of protective structures and an edge portion of the display panel shown in FIG. 1.
FIG. 10 is another schematic cross-sectional structural view of protective structures and an edge portion of the display panel shown in FIG. 1.
FIG. 11 is yet another schematic cross-sectional structural view of a protective structures and an edge portion of the display panel shown in FIG. 1.
FIG. 12 is another schematic cross-sectional structural view of the display panel shown in FIG. 1.
FIG. 13 is a schematic cross-sectional structural partial view of the display panel shown in FIG. 12.
FIG. 14 is yet another schematic cross-sectional structural view of the display panel shown in FIG. 1.

### Reference signs of drawings

100. stretchable display panel; 1. substrate; 2. pixel island; 2a. light-emitting area; 2b. non-light-emitting area; 2b1. transitional area; 2b2. encapsulation area; 21. driving layer group; 211. base layer; 2111. main body portion; 2112. edge portion; 212. interlayer insulating layer; 213. planarizing layer; 2131. recess portion; 214. connecting line; 2141. first connecting line portion; 2142. second connecting line portion; 2143. third connecting line portion; 2144. first through-hole structure; 2145. second through-hole structure; 215. gate electrode insulating layer; 216. capacitance insulating layer; 217. blocking layer; 218. buffer layer; 219. gate electrode; 22. pixel-defining structure; 23. light-emitting unit; 231. first electrode; 232. light-emitting functional portion; 233. second electrode; 24. encapsulating layer; 25. groove; 251. first groove segment; 252. first main groove; 253. first sub-groove; 253a. first end; 253b. second end; 26. protective structure; 26a. concave portion; 26b. sub-structure; 261. first sub-portion; 262. second sub-portion; 263. third sub-portion; 27. encapsulation auxiliary structure; 271. slot; 272. protrusion portion; 3. connecting wire.

### DETAILED DESCRIPTION

The present application will be described in detail with reference to the accompanying drawings in order to facilitate understanding of the present application. The embodiments of the present application are provided in the drawings, but the present application can be implemented in many different forms and is not limited to the embodiments described herein. In contrast, these embodiments provided are only for thorough and comprehensive understanding of the contents of the present application.

At present, flexible display panels have made great progress. Therefore, curved, foldable and stretchable display panels have very broad development prospects in the fields of smart wearable, automotive equipment, etc. In the related stretchable display technologies, the poor adhesion between the encapsulating layer and the pixel defining layer or the array layer group leads to unstable contact, resulting in the encapsulating layer being prone to cracking during etching, peeling, and tensile testing, causing failure of the pixel islands.

In view of the above, the present application provides embodiments of a stretchable display panel and a display device, which have enhanced encapsulation reliability.

It can be understood that the stretchable display panel can be a stretchable organic light-emitting diode (OLED) display panel, a stretchable quantum dot light-emitting diode (QLED) display panel, etc.

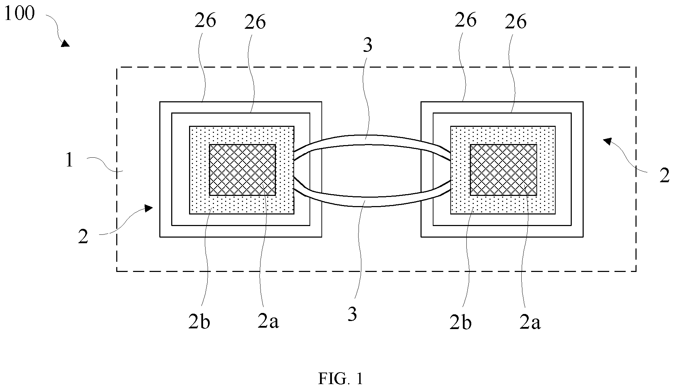

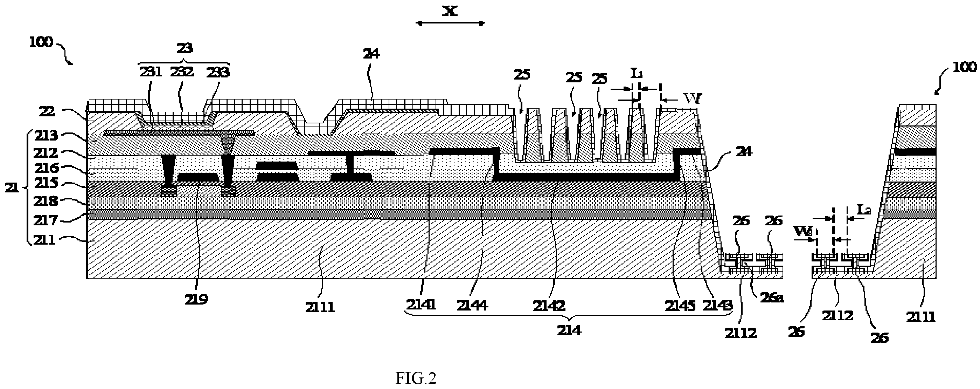

In a first aspect, referring to FIG. 1 and FIG. 2, an embodiment of the present application provides a stretchable display panel 100. The stretchable display panel 100 includes a substrate 1 and a plurality of pixel islands 2. The plurality of pixel islands 2 are disposed on the substrate 1 and are spaced from each other. The pixel island 2 has a light-emitting area 2a and a non-light-emitting area 2b adjacent to the light-emitting area 2a. In some embodiments, the substrate 1 is a flexible substrate and is stretchable.

Specifically, the pixel island 2 includes a driving layer group 21, a pixel-defining structure 22, a light-emitting unit 23, and an encapsulating layer 24. The driving layer group 21 is disposed on the substrate 1. The pixel-defining structure 22 is disposed on the driving layer group 21. The pixel-defining structure 22 defines a pixel opening located in the light-emitting area 2a. At least one groove 25 is located in the non-light-emitting area 2b and located at a side of the pixel-defining structure 22 away from the driving layer group 21. The groove 25 extends through the pixel-defining structure 22 and a part of the driving layer group 21 along a thickness direction of the substrate 1. The light-emitting unit 23 is disposed in the pixel opening. The encapsulating layer 24 covers a surface of the light-emitting unit 23 away from the substrate 1 and a surface of the groove 25.

In some embodiments of the present application, the encapsulating layer 24 is an inorganic encapsulating film layer. The encapsulating layer 24 extends from the surface of the light-emitting unit 23 toward the non-light-emitting area 2b, and covers the exposed surface of the pixel-defining structure 22 and the surface of the groove 25. It should be not that when A is referred to as covering a side, a surface, a wall, etc. of B, A is in direct contact with B.

It should be noted that the groove 25 extends through the pixel-defining structure 22 and a part of the driving layer group 21 along the thickness direction of the substrate 1, which means that a part of the side wall of the groove 25 is located in the pixel-defining structure 22, and the bottom and another part of the side wall of the groove 25 are located in the driving layer group 21.

The groove 25 extends through a part of the driving layer group 21, so that the depth of the groove 25 can be increased, thereby increasing the area of the surface of the groove 25. In addition, the encapsulating layer 24 covers the surface of the groove 25, so that the area covered by the encapsulating layer 24 is increased.

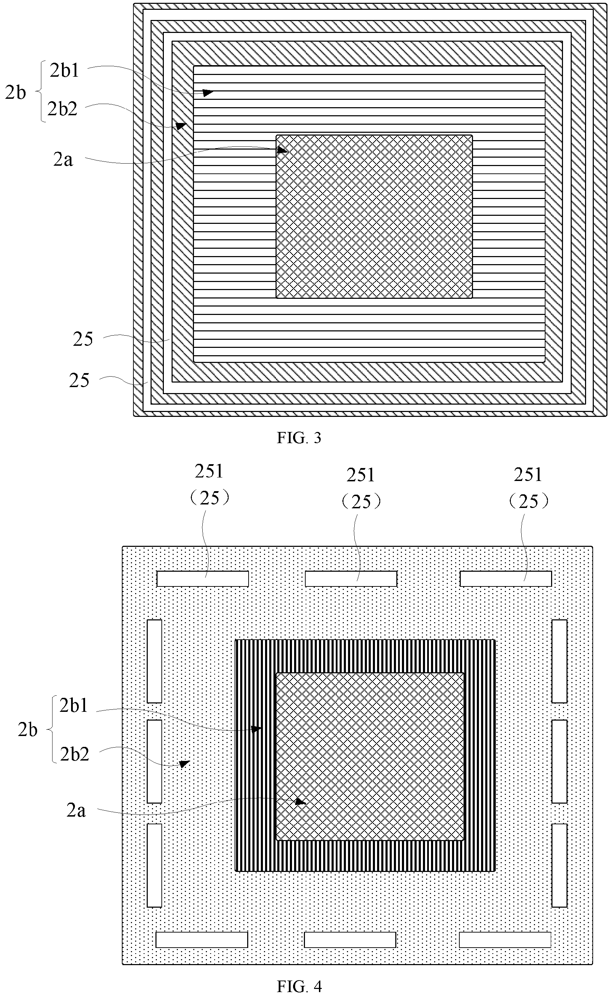

In some embodiments of the present application, referring to FIG. 3, the non-light-emitting area 2b includes a transitional area 2b 1 and an encapsulation area 2b2. The transitional area 2b1 is located between the encapsulation area 2b2 and the light-emitting area 2a. For example, the groove 25 can be located in the encapsulation area 2b2. Further, the non-light-emitting area 2b surrounds a periphery of the light-emitting area 2a.

It should be noted that, in the embodiments of the present application, the pixel-defining structure 22 can be a pixel-defining layer, or other structures for defining the position of the light-emitting unit. The specific components of the pixel-defining structure 22 are not limited in the embodiments of the present application.

In the stretchable display panel 100 provided in the embodiments of the present application, the groove 25 is disposed in the pixel-defining structure 22 and located in the non-light-emitting area 2b, the groove 25 extends through the pixel-defining structure 22 and a part of the driving layer group 21, and the encapsulating layer 24 extends to cover the surface of the groove 25. As such, on the one hand, when a crack is generated, the groove 25 can block the crack expansion to a certain extent, thereby mitigating the extending tendency of the crack toward the light-emitting area 2a. On the other hand, the groove 25 can increase the contact area of the encapsulating layer 24, enhancing the overall encapsulation reliability of the encapsulating layer 24, thereby increasing the service life of the stretchable display panel 100.

It can be understood that, in an embodiment, the driving layer group 21 includes a base layer 211, and the driving layer group 21 is disposed on the substrate 1 through the base layer 211. In another embodiment, the driving layer group 21 does not include the base layer 211. That is, the driving layer group 21 is directly disposed on the substrate 1. In this case, the substrate 1 can includes a stretching area and a pixel area. The driving layer group 21 is located in the pixel area. When the display panel is stretched, the stretching area is extended, and the pixel area is not extendable.

The light-emitting unit 23 includes a first electrode 231, a light-emitting functional portion 232, and a second electrode 233 stacked in a direction away from the substrate 1. The light-emitting functional portion 232 at least includes an emission layer (EML). The light-emitting functional portion 232 can further include one or more of a hole injection layer (HIL), a hole transport layer (HTL), an electron injection layer (EIL), an electron transport layer (ETL), a hole block layer (HBL), or an electron block layer (EBL). Alternatively, the light-emitting functional portion 232 can be a light-emitting layer stack which includes at least two emission layers and a charge generation layer (CGL) located between two adjacent emission layers.

In an embodiment, the driving layer group 21 includes an inorganic film layer and an organic film layer. The inorganic film layer is disposed between the substrate 1 and the organic film layer. The groove 25 at least extends through the organic film layer to expose a part of the inorganic film layer. The encapsulating layer 24 covers the exposed surface of the inorganic film layer.

By exposing a part of the inorganic film layer, the exposed surface of the inorganic film layer can form the surface of the groove 25. That is, a part of the surface of the groove 25 is an inorganic surface. As such, the encapsulating layer 24 is in direct contact with the inorganic surface, which can improve the film adhesion with the encapsulating layer 24, thereby further improving the encapsulation performance of the encapsulating layer 24, so as to enhance the overall encapsulation reliability of the encapsulating layer 24, and increase the service life of the stretchable display panel 100.

In an example, the groove 25 only extends through the organic film layer, ending at the upper surface of the inorganic film layer.

In an embodiment, the groove 25 extends through the organic film layer and a part of the inorganic film layer. On the one hand, the depth of the groove 25 is increased, thereby increasing the area of the surface of the groove 25. On the other hand, the bottom and a part of the side wall of the groove 25 are located in the inorganic film layer, which increases the contact area between the encapsulating layer 24 and the inorganic surface, thereby improving the film adhesion with the encapsulating layer 24, so as to further enhance the overall encapsulation reliability of the encapsulating layer 24, and increase the service life of the stretchable display panel 100.

In an embodiment, the driving layer group 21 includes an interlayer insulating layer 212 and a planarizing layer 213. The interlayer insulating layer 212 is located between the substrate 1 and the planarizing layer 213. The material of the interlayer insulating layer 212 includes an inorganic material. The material of the planarizing layer 213 includes an organic material. That is, the interlayer insulating layer 212 is an inorganic film layer, and the planarizing layer 213 is an organic film layer. The groove 25 extends through the planarizing layer 213 and a part of the interlayer insulating layer 212.

As such, on the one hand, the depth of the groove 25 is increased, thereby increasing the area of the surface of the groove 25. On the other hand, the bottom and a part of the side wall of the groove 25 are located in the interlayer insulating layer 212, which increases the contact area between the encapsulating layer 24 and the inorganic surface, thereby improving the film adhesion with the encapsulating layer 24, so as to further enhance the overall encapsulation reliability of the encapsulating layer 24, and increase the service life of the stretchable display panel 100. On the other hand, referring to FIG. 2, when the encapsulating layer 24 is in contact with the interlayer insulating layer 212, the encapsulating layer 24 can completely encapsulate the light-emitting unit 23 in the light-emitting area 2a and the planarizing layer 213 (i.e., an organic film layer). The interlayer insulating layer 212 can block infiltration of water and oxygen toward the light-emitting unit 23 from the side of the interlayer insulating layer 212 adjacent to the substrate 1, and the encapsulating layer 24 can block infiltration of water and oxygen toward the light-emitting unit 23 from the side of the encapsulating layer 24 away from the substrate 1. That is, a double-sided blocking structure is formed, which further improves the encapsulation reliability and ensures the encapsulation stability between the upper and lower film layers.

In an embodiment, the stretchable display panel 100 further includes a connecting wire 3. Adjacent pixel islands 2 are connected through the connecting wire 3. The driving layer group 21 includes a connecting line 214. The connecting line 214 is electrically connected to the connecting wire 3. For example, the driving layer group 21 includes a pixel driving circuit. One end of the connecting line 214 is connected to the pixel driving circuit, and another end of the connecting line 214 is connected to the connecting wire 3. That is, the pixel driving circuits of adjacent pixel islands 2 are connected through the connecting wire 3 and the connecting lines 214.

In an embodiment, referring to FIG. 2, the connecting line 214 includes a first connecting line portion 2141 and a second connecting line portion 2142. One end of the second connecting line portion 2142 is electrically connected to the first connecting line portion 2141, and another end of the second connecting line portion 2142 is electrically connected to the connecting wire 3. The first connecting line portion 2141 and the second connecting line portion 2142 are disposed in different layers. In an example, the end of the first connecting line portion 2141 away from the second connecting line portion 2142 is connected to the pixel driving circuit.

It should be particularly emphasized that, in the embodiments of the present application, two structures being disposed "in a (or the) same layer" means that the two structures are made of a same material and formed in a same process; and two structures being disposed "in different layers" means that the two structures are formed separately in different processes. In addition, one end of the second connecting line portion 2142 is electrically connected to the first connecting line portion 2141, and the "electrically connected" here means that the two connecting line portions can be directly electrically connected or indirectly electrically connected together. Similarly, another end of the second connecting line portion 2142 is electrically connected to the connecting wire 3, which means that the second connecting line portion 2142 and the connecting wire 3 can be directly electrically connected or indirectly electrically connected together.

It should be noted that the circuit arrangement in the driving layer group 21 may be affected by the groove 25 extended into the driving layer group 21. In some embodiments of the present application, the first connecting line portion 2141 and the second connecting line portion 2142 are disposed in different layers to avoid the groove 25, so as to optimize the layout of the connecting line 214 and reduce the influence of the groove 25 on the connecting line 214.

In an embodiment, the driving layer group 21 further includes a gate electrode insulating layer 215 and a capacitance insulating layer 216. The gate electrode insulating layer 215 and the capacitance insulating layer 216 are located between the substrate 1 and the interlayer insulating layer 212. The gate electrode insulating layer 215 is located between the substrate 1 and the capacitance insulating layer 216. The second connecting line portion 2142 is located between the gate electrode insulating layer 215 and the capacitance insulating layer 216.

As such, the second connecting line portion 2142 is disposed between the gate electrode insulating layer 215 and the capacitance insulating layer 216, which is conducive to avoiding the groove 25 and reducing the influence of the groove 25 on the connecting line 214.

In an embodiment, the driving layer group 21 further includes a gate electrode 219. The gate electrode 219 is located between the gate electrode insulating layer 215 and the capacitance insulating layer 216. The second connecting line portion 2142 and the gate electrode 219 are disposed in a same layer. As such, the gate electrode 219 and the second connecting line portion 2142 can be formed simultaneously, which simplifies the manufacturing processes of the stretchable display panel 100 and reduces the manufacturing cost.

In an embodiment, the first connecting line portion 2141 is located between the interlayer insulating layer 212 and the planarizing layer 213.

A first metal layer (M1) can disposed between the gate electrode insulating layer 215 and the capacitance insulating layer 216. The first metal layer typically includes the gate electrode 219 and a capacitor lower plate (not labeled). In some embodiments of the present application, the first metal layer further includes the second connecting line portion 2142. In some embodiments, a third metal layer (M3) is disposed between the interlayer insulating layer 212 and the planarizing layer 213. The third metal layer includes some leading wires of the pixel driving circuit. In some embodiments of the present application, the third metal layer further includes the first connecting line portion 2141, thereby simplifying the manufacturing processes of the stretchable display panel 100 and reducing the manufacturing cost.

In an embodiment, an orthographic projection of the second connecting line portion 2142 on the substrate 1 overlaps with an orthographic projection of the groove 25 on the substrate 1. Referring to FIG. 2, the groove 25 overlaps with the second connecting line portion 2142 in the vertical direction. As can be seen from FIG. 2, when the second connecting line portion 2142 is located between the interlayer insulating layer 212 and the planarizing layer 213, the groove 25 will interfere with the second connecting line portion 2142, affecting not only the arrangement of the connecting line 214 but also the arrangement of the groove 25.

In an embodiment, the first connecting line portion 2141 is electrically connected to the second connecting line portion 2142 via a first through-hole structure 2144, so that the first connecting line portion 2141 and the second connecting line portion 2142 can be electrically connected in a simple manner, facilitating the manufacturing.

In an embodiment, an orthographic projection of the first connecting line portion 2141 on the substrate 1 overlaps with an orthographic projection of the second connecting line portion 2142 on the substrate 1.

As such, during the manufacturing of the first connecting line portion 2141, the difficulty of electrical connection between the first connecting line portion 2141 and the second connecting line portion 2142 is reduced, improving the reliability of electrical connection therebetween.

In an embodiment, the connecting line 214 further includes a third connecting line portion 2143. The second connecting line portion 2142 is electrically connected to the connecting wire 3 through the third connecting line portion 2143. The third connecting line portion 2143 and the second connecting line portion 2142 are disposed in different layers.

As such, the second connecting line portion 2142 is electrically connected to the connecting wire 3 through the third connecting line portion 2143. On the one hand, the difficulty of electrical connection between the connecting line 214 and the connecting wire 3 is reduced. On the other hand, the layout of the connecting line 214 is optimized, which reduces the influence of the groove 25 on the connecting line 214.

In an embodiment, the third connecting line portion 2143 and the first connecting line portion 2141 are disposed in a same layer. As such, the first connecting line portion 2141 and the third connecting line portion 2143 can be manufactured simultaneously, which can simplify the manufacturing processes and reduce the manufacturing difficulty of the connecting line 214.

In an embodiment, the third connecting line portion 2143 is electrically connected to the second connecting line portion 2142 via a second through-hole structure 2145.

As such, the third connecting line portion 2143 and the second connecting line portion 2142 can be electrically connected in a simple manner, facilitating the manufacturing.

In an embodiment, an orthographic projection of the third connecting line portion 2143 on the substrate 1 overlaps with an orthographic projection of the second connecting line portion 2142 on the substrate 1.

As such, during the manufacturing of the third connecting line portion 2143, the difficulty of electrical connection between the third connecting line portion 2143 and the second connecting line portion 2142 is reduced, improving the reliability of electrical connection therebetween.

In an embodiment, an orthographic projection of the encapsulating layer 24 on the pixel-defining structure 22 covers the groove 25. That is, the encapsulating layer 24 completely covers the entire surface of the groove 25. As such, the encapsulating layer 24 can have a relatively large contact area, further improving the encapsulation reliability of the encapsulating layer 24.

In an embodiment, a plurality of grooves 25 are disposed in the pixel-defining structure 22. The plurality of grooves 25 are spaced from each other and located in the non-light-emitting area 2b. The encapsulating layer 24 covers the surfaces of the plurality of grooves 25.

As such, on the one hand, the grooves 25 can effectively block the crack expansion and further mitigate the extending tendency of the cracks toward the light-emitting area 2a. On the other hand, the contact area of the encapsulating layer 24 can be increased, which can enhance the encapsulation reliability of the encapsulating layer 24. Besides, the contact area between the encapsulating layer 24 and the inorganic surface can be increased, which further improves the film adhesion with the encapsulating layer 24, enhancing the overall encapsulation reliability of the encapsulating layer 24, and increasing the service life of the stretchable display panel 100.

In an embodiment, the number of the grooves 25 or the number of groove groups is not less than five, so that the encapsulating layer 24 can have further enhanced encapsulation reliability.

It should be noted that the inventors have discovered through research that by arranging the groove 25 in such a way described in the embodiments of the present application, such as arranging five groups of grooves 25, the width of the encapsulation area 2b2 can be set in a range from 20 µm to 30 µm, and the width of the non-light-emitting area 2b 1 can be reduced by about 4 µm to about 24 µm on the premise of achieving the same encapsulation effect when compared with the structure without the groove 25 in the related art, thereby being conducive to reducing the width of the encapsulation frame of the pixel island 2.

In an embodiment, referring to FIG. 3, the non-light-emitting area 2b surrounds a periphery of the light-emitting area 2a, and the grooves 25 also surround the periphery of the light-emitting area 2a. That is, the grooves 25 are disposed at all sides of the light-emitting area 2a. As such, the encapsulation reliability at all sides of the light-emitting area 2a is enhanced, thereby further increasing the service life of the stretchable display panel 100 and improving the space utilization rate of the pixel island 2. For example, the saved space can be allocated to the light-emitting area 2a or the connecting wire 3, which is beneficial to improving the service life and stretching rate of the stretchable display panel 100.

In an embodiment, the orthographic projection of the groove 25 on the substrate 1 is shaped as a closed ring. As such, the encapsulation reliability of the periphery of the light-emitting area 2a is uniformly improved, ensuring good encapsulation reliability of the encapsulating layer 24.

For example, the orthographic projection of the groove 25 on the substrate 1 can be shaped as a rectangular ring, a circular ring, a triangular ring, or the like.

In an embodiment, referring to FIG. 4, the groove 25 includes a plurality of first groove segments 251. The plurality of first groove segments 251 are spaced from each other and together surround the periphery of the light-emitting area 2a.

As such, the encapsulation reliability of the periphery of the light-emitting area 2a can be enhanced, while the occupied area of the groove 25 can be reduced, thereby reducing the cost of etching the groove 25.

In an embodiment, the plurality of first groove segments 251 uniformly surround the periphery of the light-emitting area 2a, so that the encapsulation reliability of the periphery of the light-emitting area 2a can be improved uniformly.

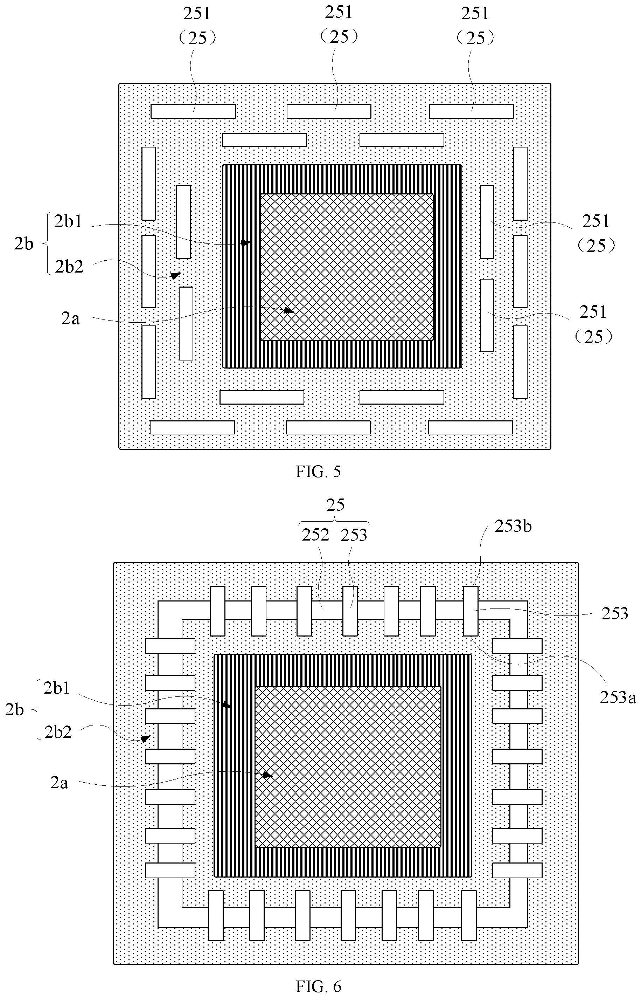

In an embodiment, referring to FIG. 5, in two adjacent grooves 25, each groove 25 includes a plurality of first groove segments 251. In the same groove 25, a gap exists between two adjacent first groove segments 251. In the two adjacent grooves 25, the gap of one groove 25 is located corresponding to one first groove segment 251 of another groove 25.

As such, the first groove segments 251 of the two adjacent grooves 25 are disposed in a staggered manner, which not only reduces the occupied area of the grooves 25 but also further improves the encapsulation reliability of the encapsulating layer 24.

In an embodiment, referring to FIG. 6, the groove 25 includes a first main groove 252 and a plurality of first sub-grooves 253. An orthographic projection of the first main groove 252 on the substrate 1 is shaped as a closed ring. The first main groove 252 surrounds the periphery of the light-emitting area 2a. The plurality of first sub-grooves 253 are spaced from each other and together surround the periphery of the light-emitting area 2a. An orthographic projection of the first sub-grooves 253 on the substrate 1 overlaps with the orthographic projection of the first main groove 252 on the substrate 1.

As such, the contact area between the encapsulating layer 24 and the groove 25 is further increased, thereby enhancing the encapsulation reliability of the encapsulating layer 24.

In an embodiment, the first sub-groove 253 includes a first end 253a and a second end 253b opposite to the first end. The first end 253a is located at the side of the first main groove 252 adjacent to the light-emitting area 2a, and the second end 253b is located at the side of the first main groove 252 away from the light-emitting area 2a. That is, the first sub-grooves 253 intersect with the first main groove 252.

As such, on the one hand, the contact area between the encapsulating layer 24 and the groove 25 is further increased, thereby enhancing the encapsulation reliability of the encapsulating layer 24. On the other hand, when the encapsulating layer 24 covers the first sub-grooves 253 and the first main groove 252, the first main groove 252 and the first sub-groove 253 form a latch structure. When peeling occurs in the encapsulating layer 24, the latch structure can alleviate expansion of the peeling. Alternatively, when the cracks in the encapsulating layer 24 extend, the latch structure can block the crack extension. Therefore, the overall encapsulation reliability of the encapsulating layer 24 is enhanced, and the service life of the stretchable display panel 100 is increased.

In an embodiment, the dimension of the orthographic projection of the groove 25 on the substrate 1 along a first direction X is a first width W₁. The distance between two adjacent grooves 25 is a first spacing L₁. The first width W₁ is greater than or equal to the first spacing L₁.

The first direction X is perpendicular to the thickness direction of the substrate 1 and perpendicular to the length direction of the orthographic projection of the groove 25 on the substrate 1.

As such, on the one hand, the difficulty of etching the groove 25 can be reduced, and the adhesion stability between the encapsulating layer 24 and the groove 25 can be increased. On the other hand, the number of the grooves 25 in a limited space can be increased.

In an embodiment, referring to FIG. 2, the driving layer group 21 includes a main body portion 2111 and an edge portion 2112 connected to the main body portion 2111. The pixel-defining structure 22 and the light-emitting unit 23 are both disposed on the main body portion 2111. The pixel island further includes at least one protective structure 26 disposed on the edge portion 2112. The protective structure 26 includes at least one concave portion 26a. The encapsulating layer 24 further covers the surface of the concave portion 26a.

The protective structure 26 is configured to mitigate the crack extension toward the main body portion 2111. Specifically, the protective structure 26 mitigates the extension of the cracks through the concave portion 26a.

In the embodiments of the present application, on the one hand, the concave portion 26a can mitigate the extending tendency of the crack toward the main body portion 2111; and on the other hand, the concave portion 26a can increase the contact area of the encapsulating layer 24, thereby enhancing the overall encapsulation reliability of the encapsulating layer 24, and further increasing the service life of the stretchable display panel 100.

In an embodiment, along the thickness direction of the substrate 1, the size of the main body portion 2111 is greater than the size of the edge portion 2112. That is, the thickness of the main body portion 2111 is greater than the thickness of the edge portion 2112.

In an embodiment, the driving layer group 21 includes a base layer 211, and the base layer 211 is disposed on the substrate 1. Other film layers of the driving layer group 21, such as a blocking layer 217, a buffer layer 218, a gate electrode insulating layer 215, a capacitance insulating layer 216, an interlayer insulating layer 212, and a planarizing layer 213, are stacked on the base layer 211.

Specifically, the main body portion 2111 and the edge portion 2112 are belonged to the base layer 211. After the formation of the base layer 211, the edge of the base layer 211 is thinned to form the edge portion 2112, and the area of the base layer 211 that is not thinned forms the main body portion 2111.

It should be noted that, when the pixel island 2 is peeled off from a glass panel, the encapsulating layer 24 at the edge portion 2112 of the pixel island 2 is easy to crack. The protective structure 26 can mitigate the extension of the cracks in the encapsulating layer 24 at the edge portion 2112 of the pixel island 2 toward a side surface of the main body portion 2111 and the light-emitting area 2a. The protective structure 26 can block and mitigate the crack extension, effectively protecting the encapsulating layer 24 on the side surface and upper surface of the pixel island 2, thereby enhancing the encapsulation reliability.

In an embodiment, the encapsulating layer 24 further covers a side surface of the pixel-defining structure 22 and a side surface of the main body portion 2111. Specifically, the encapsulating layer 24 extends along the upper surface of the pixel-defining structure 22 toward the edge portion 2112, and covers the side surface of the pixel-defining structure 22 and the side surface of the main body portion 2111 on its extending path. As such, the contact area of the encapsulating layer 24 is increased, thereby enhancing the encapsulation reliability of the encapsulating layer 24.

In an embodiment, the edge portion 2112 surrounds the periphery of the main body portion 2111, and the protective structure 26 also surrounds the periphery of the main body portion 2111.

As such, the encapsulation reliability of all sides of the light-emitting area 2a can be enhanced, thereby further improving the protection effect of the protective structure 26.

In an embodiment, referring to FIG. 2, a plurality of protective structures 26 spaced from each other are disposed on the edge portion 2112. The encapsulating layer 24 covers the concave portion 26a of each protective structure 26.

As such, by increasing the number of the protective structures 26, multiple layers of protection are created, which can further enhance the encapsulation reliability and the protection effect.

In an embodiment, in two adjacent protective structures 26, one protective structure 26 surrounds the periphery of the main body portion 2111, and another protective structure 26 surrounds the periphery of the one protective structure 26.

As such, the two protective structures 26 coaxially surround the periphery of the light-emitting area 2a, which is conducive to forming multiple layers of protective structures 26 that are coaxially arranged around the periphery of the light-emitting area 2a, thereby further enhancing the encapsulation reliability and the protection effect.

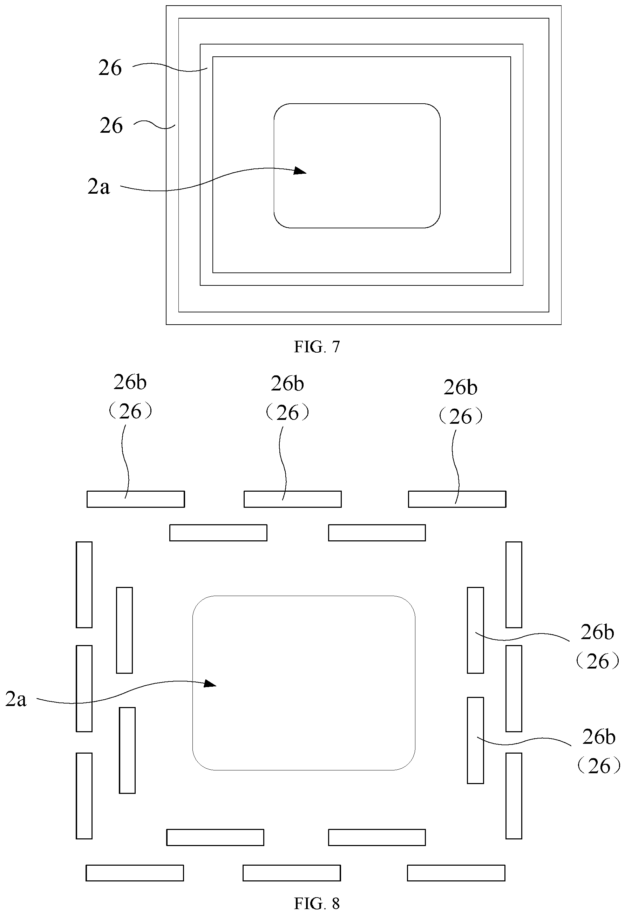

In an embodiment, referring to FIG. 8, the protective structure 26 includes a plurality of sub-structures 26b, and the plurality of sub-structures 26b are spaced from each other and together surround the periphery of the main body portion 2111.

As such, the encapsulation reliability of the periphery of the light-emitting area 2a can be enhanced, while the occupied area of the protective structure 26 can be reduced.

In an embodiment, the plurality of sub-structures 26b uniformly surround the periphery of the light-emitting area 2a, so that the encapsulation reliability of the periphery of the light-emitting area 2a can be uniformly enhanced.

In an embodiment, referring to FIG. 8, in two adjacent protective structures 26, each protective structure 26 includes a plurality of sub-structures 26b. In the same protective structure 26, a gap exists between two adjacent sub-structures 26b. In the two adjacent protective structures 26, the gap of one protective structure 26 is located corresponding to one sub-structure 26b of another protective structure 26.

As such, the sub-structures 26b of the two adjacent protective structures 26 are disposed in a staggered manner, which not only reduces the occupied area of the protective structure 26, but also further enhances the encapsulation reliability of the encapsulating layer 24.

In an embodiment, referring to FIG. 2, the dimension of the orthographic projection of the protective structure 26 on the substrate 1 along the first direction X is a second width W₂. The distance between two adjacent protective structures 26 is a second spacing L₂. The second width W₂ is greater than or equal to the second spacing L₂.

The first direction X is perpendicular to the thickness direction of the substrate 1 and perpendicular to the length direction of the protective structure 26.

As such, on the one hand, the adhesion stability between the encapsulating layer 24 and the protective structure 26 can be increased, and the space occupied by the protective structure 26 can be reduced. On the other hand, the encapsulating layer 24 can be deposited between two adjacent protective structures 26, ensuring good structural contact between the encapsulating layer 24 and the two protective structures 26, thereby enhancing the encapsulation reliability of the encapsulating layer 24.

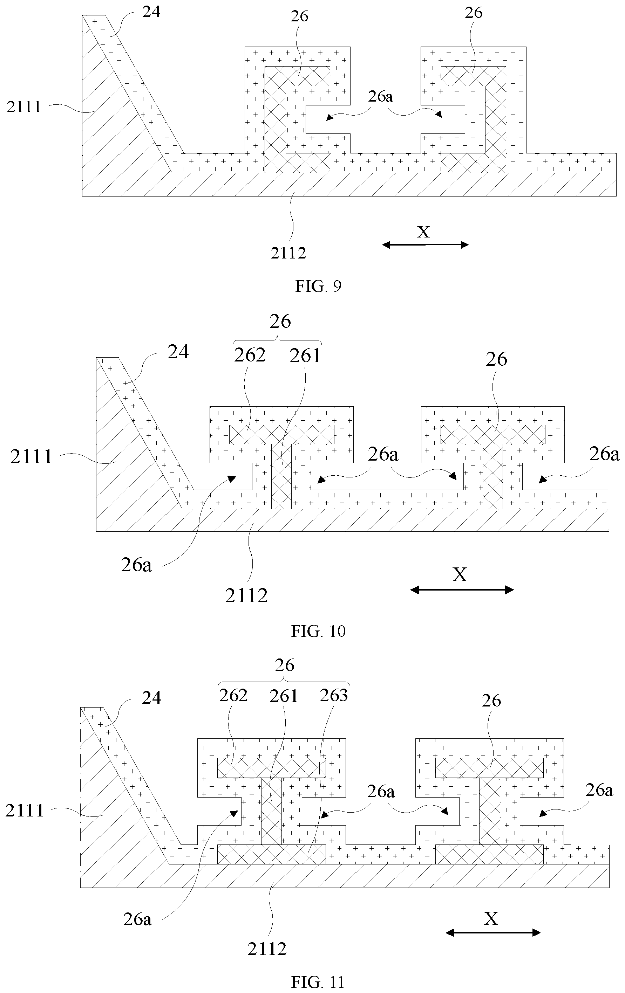

In some embodiments of the present application, the concave portion 26a is located on at least one side of the protective structure 26 along the first direction X. In an embodiment, referring to FIG. 9, the protective structure 26 includes a concave portion 26a at one side along the first direction X. Specifically, along the direction perpendicular to the drawing, the cross section of the protective structure 26 has a "C" shape.

In an embodiment, the protective structure 26 includes a plurality of concave portions 26a, and the encapsulating layer 24 covers surfaces of the plurality of concave portions 26a. As such, on the one hand, the protective structure 26 can more effectively block the crack expansion; and on the other hand, the contact area between the encapsulating layer 24 and the protective structure 26 can be increased, thereby enhancing the overall encapsulation reliability of the encapsulating layer 24, and further increasing the service life of the stretchable display panel 100.

In an embodiment, referring to FIG. 10 and FIG. 11, the protective structure 26 includes two concave portions 26a, and openings of the two concave portions 26a are opposite to each other.

As such, when the encapsulating layer 24 completely covers the two concave portions 26a of the protective structure 26, on the one hand, when the cracks in the encapsulating layer 24 extend, they extends along relatively tortuous paths, increasing the difficulty of crack extension, thereby further blocking the crack expansion; on the other hand, when peeling occurs in the encapsulating layer 24, the two concave portions 26a of the protective structure 26 form a latch structure to lock the encapsulating layer 24, thereby reducing the peeling tendency of the encapsulating layer 24.

In an embodiment, referring to FIG. 10, the protective structure 26 includes a first sub-portion 261 and a second sub-portion 262 which are sequentially stacked on the edge portion 2112. Two opposite ends of the second sub-portion 262 along the first direction X respectively protrude from the side surfaces of the first sub-portion 261. The first direction X is perpendicular to the thickness direction of the substrate 1. The first sub-portion 261, the protruding portion of the second sub-portion 262, and the edge portion 2112 together define the concave portion 26a. As such, the protective structure 26 can have a simple structure.

Specifically, referring to FIG. 10, along the direction perpendicular to the drawing, the cross section of the protective structure 26 has a "T" shape.

In an embodiment, referring to FIG. 11, the protective structure 26 includes a third sub-portion 263, a first sub-portion 261, and a second sub-portion 262 which are sequentially stacked on the edge portion 2112. Two opposite ends of the third sub-portion 263 along the first direction X respectively protrude from the side surfaces of the first sub-portion 261. Two opposite ends of the second sub-portion 262 along the first direction X respectively protrude from the side surfaces of the first sub-portion 261. The first direction X is perpendicular to the thickness direction of the substrate 1. The protruding portion of the third sub-portion 263, the first sub-portion 261, and the protruding portion of the second sub-portion 262 together define the concave portion 26a. As such, the contact area between the protective structure 26 and the encapsulating layer 24 is increased, which is conducive to improving the adhesion stability between the protective structure 26 and the encapsulating layer 24.

Specifically, referring to FIG. 11, along the direction perpendicular to the drawing, the cross section of the protective structure 26 has an "I" shape.

In an embodiment, the third sub-portion 263 and the second sub-portion 262 are made of a same material.

In an embodiment, the third sub-portion 263 and the first section 261 are made of different materials.

In an embodiment, the material of the third sub-portion 263 includes titanium, and the material of the first sub-portion 261 includes aluminum. That is, the protective structure 26 is a structure composed of three metal layers of titanium-aluminum-titanium. As such, the protective structure 26 can be formed by side-etching a metal layer stack. It can be understood that the protective structure 26 can be alternatively a metal layer stack made of other materials.

In a second aspect, referring to FIG. 1, FIG. 12, FIG. 13 and FIG. 14, an embodiment of the present application provides another stretchable display panel 100. The stretchable display panel 100 includes a substrate 1 and a plurality of pixel islands 2. The plurality of pixel islands 2 are disposed on the substrate 1 and are spaced from each other. The pixel island 2 has a light-emitting area 2a and a non-light-emitting area 2b adjacent to the light-emitting area 2a. In some embodiments, the substrate 1 is a flexible substrate 1 and is stretchable.

Specifically, the pixel island 2 includes a driving layer group 21, a light-emitting unit 23, an encapsulation auxiliary structure 27, and an encapsulating layer 24. The driving layer group 21 is disposed on the substrate 1. The light-emitting unit 23 is disposed on the driving layer group 21 and is located in the light-emitting area 2a. The encapsulation auxiliary structure 27 is disposed on the driving layer group 21 and is located in the non-light-emitting area 2b. At least one slot 271 is disposed at a side of the encapsulation auxiliary structure 27 away from the driving layer group 21. The encapsulation auxiliary structure 27 includes an inorganic material. The encapsulating layer 24 covers a surface of the light-emitting unit 23 away from the substrate 1 and a surface of the slot 271.

In some embodiments of the present application, the encapsulating layer 24 is an inorganic encapsulating film layer. The encapsulating layer 24 extends from the surface of the light-emitting unit 23 toward the non-light-emitting area 2b, and covers the surface of the encapsulation auxiliary structure 27 and the surface of the slot 271.

It should be noted that the slot 271 is an inorganic slot. That is, the surface of the slot 271 is made of an inorganic material. In some embodiments of the present application, referring to FIG. 3, the non-light-emitting area 2b includes a transitional area 2b1 and an encapsulation area 2b2. The transitional area 2b 1 is located between the encapsulation area 2b2 and the light-emitting area 2a. For example, the encapsulation auxiliary structure 27 can be disposed in the encapsulation area 2b2. Further, the non-light-emitting area 2b surrounds a periphery of the light-emitting area 2a.

According to the stretchable display panel 100 provided in the embodiments of the present application, the encapsulation auxiliary structure 27 is disposed on the driving layer group 21, the slot 271 is disposed in the encapsulation auxiliary structure 27, and the encapsulating layer 24 extends to cover the surface of the slot 27. As such, on the one hand, the slot 271 can mitigate the extending tendency of cracks toward the light-emitting area 2a. On the other hand, the slot 271 can increase the contact area of the encapsulating layer 24, improving the encapsulation performance of the encapsulating layer 24. Besides, the encapsulating layer 24 is in direct contact with the inorganic slot 271, and that is, an inorganic film layer is in contact with another inorganic film layer, thereby improving the film adhesion of the encapsulating layer 24, which further improves the encapsulation performance of the encapsulating layer 24, thereby enhancing the overall encapsulation reliability of the encapsulating layer 24, and increasing the service life of the stretchable display panel 100.

In an embodiment, a plurality of slots 271 are spaced from each other and disposed at the side of the encapsulation auxiliary structure 27 away from the driving layer group 21. The encapsulating layer 24 covers the surfaces of the plurality of slots 271.

As such, on the one hand, the slots 271 can effectively block the crack expansion and further mitigate the extending tendency of the cracks toward the light-emitting area 2a. On the other hand, the contact area between the encapsulating layer 24 and the inorganic surfaces of the slots 271 can be increased, which can further improve the film adhesion of the encapsulating layer 24, thereby enhancing the overall encapsulation reliability of the encapsulating layer 24, and increasing the service life of the stretchable display panel 100.

In an embodiment, the number of the slots 271 or the number of slot groups is not less than 5, so that the encapsulating layer 24 can have further enhanced encapsulation reliability.

It should be noted that the inventors have discovered through research that by arranging the slot 271 in such a way described in the embodiments of the present application, such as arranging five groups of slots 271, the width of the non-light-emitting area 2b 1 can be reduced by about 14 µm to about 24 µm on the premise of achieving the same encapsulation effect when compared with the structure without the slot 271 in the related art, thereby being conducive to reducing the width of the encapsulation frame of the pixel island 2.

In an embodiment, an orthographic projection of the encapsulating layer 24 on the substrate 1 covers an orthographic projection of the slot 271 on the substrate 1. That is, the encapsulating layer 24 completely covers the entire surfaces of the slots 271. As such, the encapsulating layer 24 can have a relatively large contact area, further improving the encapsulation reliability of the encapsulating layer 24.

It should be noted that the layout of the slots 271 in the embodiments of the present application can refer to the layout of the grooves 25 shown in FIG. 3 to FIG. 6.

In an embodiment, the encapsulation auxiliary structure 27 surrounds the periphery of the light-emitting area 2a, and the slots 271 also surround the periphery of the light-emitting area 2a. That is, the slots 271 are disposed at all sides of the light-emitting area 2a. As such, the encapsulation reliability at all sides of the light-emitting area 2a is enhanced, thereby further increasing the service life of the stretchable display panel 100.

In an embodiment, the orthographic projection of the slot 271 on the substrate 1 is shaped as a closed ring. As such, the encapsulation reliability of the periphery of the light-emitting area 2a can be uniformly improved, ensuring good encapsulation reliability of the encapsulating layer 24.

For example, the orthographic projection of the slot 271 on the substrate 1 can be shaped as a rectangular ring, a circular ring, a triangular ring, or the like.

In an embodiment, the slot 271 includes a plurality of second slot segments, and the plurality of second slot segments are spaced from each other and together surround the periphery of the light-emitting area 2a.

As such, the encapsulation reliability of the periphery of the light-emitting area 2a can be enhanced, while the occupied area of the slot 271 can be reduced, thereby reducing the cost of etching the slot 271.

In an embodiment, the plurality of second slot segments uniformly surround the periphery of the light-emitting area 2a, so that the encapsulation reliability of the periphery of the light-emitting area 2a can be uniformly improved.

In an embodiment, in two adjacent slots 271, each slot 271 includes a plurality of second slot segments. In the same slot 271, a gap exists between two adjacent second slot segments. In the two adjacent slots 271, the gap of one slot 271 is located corresponding to one second slot segment of another slot 271.

As such, the second slot segments of the two adjacent slots 271 are disposed in a staggered manner, which not only reduces the occupied area of the slot 271 but also further improves the encapsulation reliability of the encapsulating layer 24.

In an embodiment, the slot 271 includes a second main slot and a plurality of second sub-slot. An orthographic projection of the second main slot on the substrate 1 is shaped as a closed ring. The second main slot surrounds the periphery of the light-emitting area 2a. The plurality of second sub-slots are spaced from each other and together surround the periphery of the light-emitting area 2a. An orthographic projection of the second sub-slots on the substrate 1 overlaps with the orthographic projection of the second main slot on the substrate 1.

As such, the contact area between the encapsulating layer 24 and the slot 271 is further increased, thereby enhancing the encapsulation reliability of the encapsulating layer 24.

In an embodiment, the second sub-slot includes a third end and a fourth end opposite to the third end. The third end is located at the side of the second main slot adjacent to the light-emitting area 2a, and the fourth end is located at the side of the second main slot away from the light-emitting area 2b. That is, the second sub-slots intersect with the second main slot.

As such, on the one hand, the contact area between the encapsulating layer 24 and the slot 271 is further increased, thereby enhancing the encapsulation reliability of the encapsulating layer 24. On the other hand, when the encapsulating layer 24 covers the second sub-slots and the second main slot, the second main slot and the second sub-slot form a latch structure. When peeling occurs in the encapsulating layer 24, the latch structure can alleviate expansion of the peeling. Alternatively, when the cracks in the encapsulating layer 24 extend, the latch structure can block the crack extension. Thus, the overall encapsulation reliability of the encapsulating layer 24 is enhanced, and the service life of the stretchable display panel 100 is increased.

In an embodiment, the dimension of the orthographic projection of the slot 271 on the substrate 1 along a first direction X is a third width W₃. The distance between two adjacent slots 271 is a third spacing L₃. The third width W₃ is greater than or equal to the third spacing L₃.

The first direction X is perpendicular to the thickness direction of the substrate 1, and perpendicular to the length direction of the orthographic projection of the slot 271 on the substrate 1.

As such, on the one hand, the difficulty of etching the slot 271 can be reduced, and the adhesion stability between the encapsulating layer 24 and the slot 271 can be increased. On the other hand, the number of the slots 271 in a limited space can be increased.

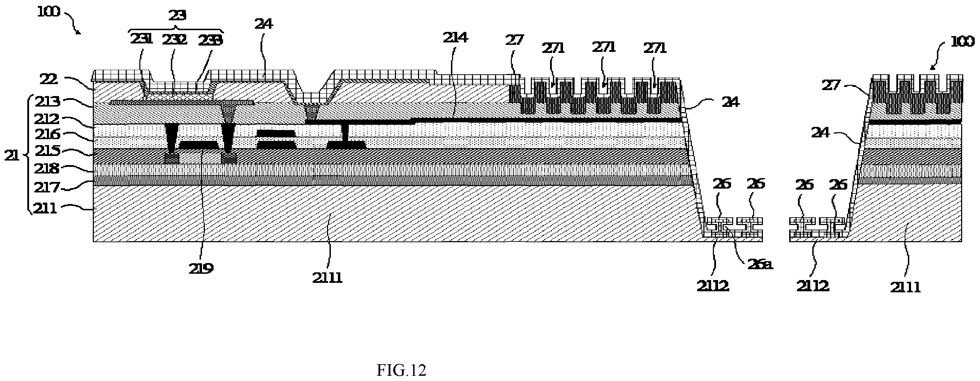

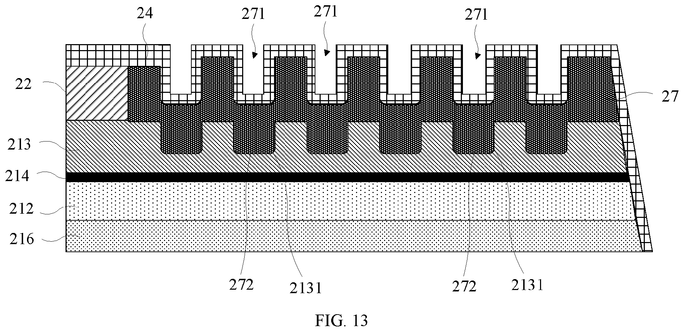

In an embodiment, referring to FIG. 12 and FIG. 13, the encapsulation auxiliary structure 27 includes at least one protrusion portion 272 disposed at a side adjacent to the driving layer group 21, and the driving layer group 21 includes at least one recess portion 2131 disposed at a side adjacent to the encapsulation auxiliary structure 27. The at least one protrusion portion 272 mates with the at least one recess portion 2131.

Through the protrusion portion 272 and the recess portion 2131, the contact area between the encapsulation auxiliary structure 27 and the driving layer group 21 can be increased, which increases the bonding force between the encapsulation auxiliary structure 27 to the driving layer group 21, thereby improving the stability of the encapsulation auxiliary structure 27.

In an embodiment, the encapsulation auxiliary structure 27 includes a plurality of protrusion portions 272 spaced from each other and disposed at a side adjacent to the driving layer group 21, and the driving layer group 21 includes a plurality of recess portions 2131 disposed at a side adjacent to the encapsulation auxiliary structure 27. The plurality of protrusion portions 272 mate with the plurality of recess portions 2131 in a one-to-one correspondence.

As such, the contact area between the encapsulation auxiliary structure 27 and the driving layer group 21 can be further increased, which increases the bonding force between the encapsulation auxiliary structure 27 to the driving layer group 21, thereby improving the stability of the encapsulation auxiliary structure 27.

In an embodiment, a plurality of slots 271 are spaced from each other and disposed in the encapsulation auxiliary structure 27. An orthographic projection of the slot 271 on the driving layer group 21 overlaps with an orthographic projection of the protrusion portion 272 on the driving layer group 21. That is, the orthographic projection of the slot 271 on the driving layer group 21 falls within the orthographic projection of the protrusion portion 272 on the driving layer group 21. In other words, the position of the slot 271 is in alignment with the position of the protrusion portion 272.

In an embodiment, the orthographic projections of two slots 271 on the driving layer group 21 both fall within the orthographic projection of one protrusion portion 272 on the driving layer group 21.

It should be noted that, by providing the protrusion portion 272 and the slot 271 disposed at the side of the protrusion portion 272 away from the substrate 1, on the one hand, the slot 271 can be relatively deep, thereby increasing the contact area between the encapsulating layer 24 and the slot 271; on the other hand, the thickness of the encapsulation auxiliary structure 27 (i.e., the size of the encapsulation auxiliary structure 27 along the thickness direction of the substrate 1) at various positions can be increased, ensuring relatively high structural strength of the encapsulation auxiliary structure 27, so that the encapsulation auxiliary structure 27 is less likely to break.

In an embodiment, the plurality of slots 271 and the plurality of protrusion portions 272 are in a one-to-one correspondence. An orthographic projection of each slot 271 on the driving layer group 21 overlaps with an orthographic projection of the corresponding protrusion portion 272 on the driving layer group 21. That is, the slots 271 and the protrusion portions 272 are opposite to each other in a one-to-one correspondence at both sides of the encapsulation auxiliary structure 27.

As such, the thickness of the encapsulation auxiliary structure 27 (i.e., the size of the encapsulation auxiliary structure 27 along the thickness direction of the substrate 1) at various positions can be increased, ensuring relatively high structural strength of the encapsulation auxiliary structure 27, so that the encapsulation auxiliary structure 27 is less likely to break.

In an embodiment, the driving layer group 21 includes a planarizing layer 213. The recess portion 2131 is disposed on a surface of the planarizing layer 213 away from the substrate 1.

In an embodiment, the pixel island 2 further includes a pixel-defining structure 22. The pixel-defining structure 22 is disposed on the surface of the planarizing layer 213 away from the substrate 1. The pixel-defining structure 22 defines a pixel opening located in the light-emitting area 2a. The light-emitting unit 23 is disposed in the pixel opening.

In an embodiment, along the thickness direction of the substrate 1, the size of the recess portion 2131 is Hi, and the size of the planarizing layer 213 is H₂. H₁ and H₂ satisfy a relationship of H₁ ≤ 0.5H₂.

As such, the planarizing layer 213 located directly below the recess portion 2131 can be relatively thick, ensuring the structural strength of the planarizing layer 213, so that the planarizing layer 213 is less likely to break.

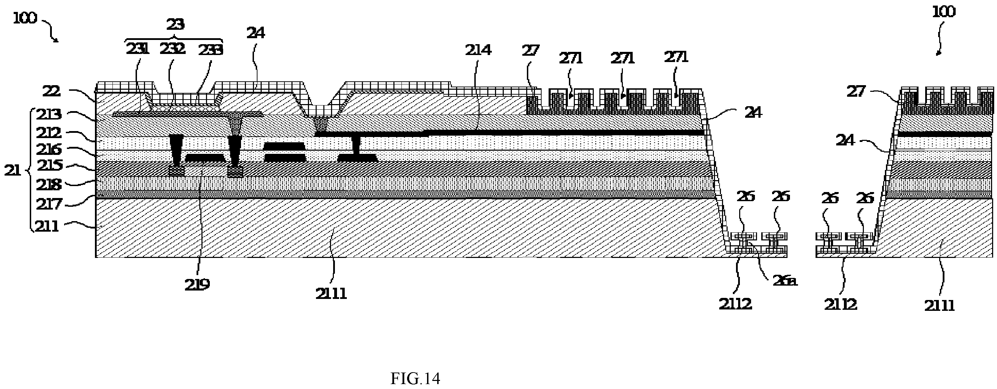

In an embodiment, referring to FIG. 14, a surface of the encapsulation auxiliary structure 27 adjacent to the driving layer group 21 is a flat surface. As such, the manufacturing difficulty of the encapsulation auxiliary structure 27 can be reduced.

In an embodiment, the stretchable display panel 100 includes a pixel-defining structure 22. The pixel-defining structure 22 is disposed on the driving layer group 21. The pixel-defining structure 22 defines a pixel opening located in the light-emitting area 2a. The light-emitting unit 23 is disposed in the pixel opening. A surface of the pixel-defining structure 22 adjacent to the driving layer group 21 is flush with the surface of the encapsulation auxiliary structure 27 adjacent to the driving layer group 21. As such, the pixel-defining structure 22 and the encapsulation auxiliary structure 27 can be formed on the same surface of the same film layer, avoiding adverse effect of the encapsulation auxiliary structure 27 on the layout of the connecting lines and the layout of the film layers in the driving layer group 21.

In a specific embodiment, the driving layer group 21 includes a planarizing layer 213. The pixel-defining structure 22 and the encapsulation auxiliary structure 27 are disposed on the surface of the planarizing layer 213 away from the substrate 1.

In an embodiment, the pixel-defining structure 22 is adjacent to the encapsulation auxiliary structure 27, which is beneficial for the encapsulating layer 24 extends from the surface of the pixel-defining structure 22 to the surface of the encapsulation auxiliary structure 27, thereby forming a continuous film layer structure.

In an embodiment, the driving layer group 21 includes a main body portion 2111 and an edge portion 2112 connected to the main body portion 2111. The light-emitting unit 23 is disposed on the main body portion 2111. The pixel island 2 further includes at least one protective structure 26 disposed on the edge portion 2112. The protective structure 26 includes at least one concave portion 26a. The encapsulating layer 24 further covers a surface of the concave portion 26a.

In an embodiment, the stretchable display panel 100 includes a pixel-defining structure 22. The pixel-defining structure 22 is disposed on the main body portion 2111. The pixel-defining structure 22 defines a pixel opening located in the light-emitting area 2a. The light-emitting unit 23 is disposed in the pixel opening. The encapsulating layer 24 further covers a side surface of the pixel-defining structure 22 and a side surface of the main body portion 2111. Specifically, the encapsulating layer 24 extends along the upper surface of the pixel-defining structure 22 toward the edge portion 2112, and covers the side surface of the pixel-defining structure 22 and the side surface of the main body portion 2111 on its extending path. As such, the contact area of the encapsulating layer 24 is increased, thereby enhancing the encapsulation reliability of the encapsulating layer 24.

In an embodiment, referring to FIG. 10 and FIG. 11, the protective structure 26 includes two concave portions 26a, and openings of the two concave portions 26a are opposite to each other.

As such, when the encapsulating layer 24 completely covers the two concave portions 26a of the protective structure 26, on the one hand, when the cracks in the encapsulating layer 24 extend, they extends along relatively tortuous paths, increasing the difficulty of crack extension, thereby further blocking the crack expansion; on the other hand, when peeling occurs in the encapsulating layer 24, the two concave portions 26a of the protective structure 26 form a latch structure to lock the encapsulating layer 24, thereby reducing the peeling tendency of the encapsulating layer 24.

In an embodiment, referring to FIG. 12 and FIG. 14, the stretchable display panel 100 further includes a connecting wire 3. Adjacent pixel islands 2 are connected through the connecting wire 3. The driving layer group 21 includes a connecting line 214, and the connecting line 214 is electrically connected to the connecting wire 3. For example, the driving layer group 21 includes a pixel driving circuit. One end of the connecting line 214 is connected to the pixel driving circuit, and another end of the connecting line 214 is connected to the connecting wire 3. That is, the pixel driving circuits of adjacent pixel islands 2 are connected through the connecting wire 3 and the connecting lines 214.

In an embodiment, the connecting line 214 is disposed between the interlayer insulating layer 212 and the planarizing layer 213.

In some embodiments, a third metal layer (M3) can be disposed between the interlayer insulating layer 212 and the planarizing layer 213. The third metal layer includes some leading wires of the pixel driving circuit. In some embodiment of the present application, the third metal layer further includes the connecting line 214, thereby simplifying the manufacturing processes of the stretchable display panel 100 and reducing the manufacturing cost.

In addition, the display panel provided by the second aspect can reduce the adverse effect on the connecting line 214 in the driving layer group 21 caused by the layout of the slots 271, thereby reducing the manufacturing cost of the display panel.

In a third aspect, referring to FIG. 2, FIG. 12 and FIG. 14, an embodiment of the present application provides yet another stretchable display panel 100. The stretchable display panel 100 includes a substrate 1 and a plurality of pixel islands 2. The plurality of pixel islands 2 are disposed on the substrate 1 and spaced from each other. The pixel island 2 has a light-emitting area 2a and a non-light-emitting area 2b adjacent to the light-emitting area 2a. In some embodiments, the substrate 1 is a flexible substrate 1 and is stretchable.

Specifically, the pixel island 2 includes a driving layer group 21, a pixel-defining structure 22, a light-emitting unit 23, and an encapsulating layer 24. The driving layer group 21 is disposed on the substrate 1. The driving layer group 21 includes a main body portion 2111 and an edge portion 2112 connected to the main body portion 2111. The light-emitting unit 23 is disposed on the main body portion 2111. The pixel island further includes at least one protective structure 26 disposed on the edge portion 2112. The protective structure 26 includes at least one concave portion 26a. The encapsulating layer 24 covers a surface of the light-emitting unit 23 away from the substrate 1 and a surface of the concave portion 26a.

In some embodiments, the encapsulating layer 24 is an inorganic encapsulating layer film layer. The encapsulating layer 24 extends from the surface of the light-emitting unit 23 toward the edge portion 2112, and covers the surface of the protective structure 26 and the surface of the concave portion 26a.

The protective structure 26 is configured to mitigate the crack extension toward the main body portion 2111. Specifically, the protective structure 26 mitigates the extension of the cracks through the concave portion 26a.

In the stretchable display panel 100 provided in the embodiments of the present application, the protective structure 26 is disposed on the edge portion 2112 and includes the concave portion 26a, and the encapsulating layer 24 extends to and cover the surface of the concave portion 26a. On the one hand, the concave portion 26a can mitigate the extending tendency of the cracks toward the main body portion 2111; and on the other hand, the concave portion 26a can increase the contact area of the encapsulating layer 24, thereby enhancing the overall encapsulation reliability of the encapsulating layer 24, and further increasing the service life of the stretchable display panel 100.

In an embodiment, the driving layer group 21 includes a base layer 211, and the driving layer group 21 is disposed on the substrate 1 through the base layer 211. In another embodiment, the driving layer group 21 does not include the base layer 211. That is, the driving layer group 21 is directly disposed on the substrate 1. In this case, the substrate 1 can includes a stretching area and a pixel area. The driving layer group 21 is located in the pixel area. When the display panel is stretched, the stretching area is extended, and the pixel area is not extendable.

It can be understood that the material of the protective structure 26 can be an inorganic material, so as to improve the adhesion between the encapsulating layer 24 and the protective structure 26, thereby enhancing the encapsulation reliability.

In an embodiment, the driving layer group 21 includes a base layer 211 and a functional layer group disposed on the base layer 211. The base layer includes the main body portion 2111 and the edge portion 2112. As such, after the formation of the base layer 211, the edge of the base layer 211 is thinned to form the edge portion 2112, and the area of the base layer 211 that is not thinned forms the main body portion 2111.

Furthermore, the encapsulating layer 24 further covers a side surface of the functional layer group. That is, the encapsulating layer 24 extends toward the edge portion 2112 and covers the side surface of the functional layer group on its extending path. As such, the contact area of the encapsulating layer 24 can be increased, thereby enhancing the encapsulation reliability of the encapsulating layer 24.

In an embodiment, the functional layer group includes a blocking layer 217 and a buffer layer 218 which are stacked one on another. The blocking layer 217 is located between the base layer 211 and the buffer layer 218. The encapsulating layer 24 further covers side surfaces of the blocking layer 217 and the buffer layer 218. That is, the encapsulating layer 24 extends toward the edge portion 2112, and covers the side surfaces of the blocking layer 217 and the buffer layer 218 on its extending path. As such, the contact area of the encapsulating layer 24 can be increased, thereby enhancing the encapsulation reliability of the encapsulating layer 24.

In an embodiment, the functional layer group further includes a gate electrode insulating layer 215 disposed at a side of the buffer layer 218 away from the base layer 211. The encapsulating layer 24 further covers a side surface of the gate electrode insulating layer 215. That is, the encapsulating layer 24 extends toward the edge portion 2112, and covers the side surface of the gate electrode insulating layer 215 on its extending path. As such, the contact area of the encapsulating layer 24 can be increased, thereby enhancing the encapsulation reliability of the encapsulating layer 24.

In an embodiment, the functional layer group further includes a capacitance insulating layer 216 disposed at a side of the gate electrode insulating layer 215 away from the base layer 211. The encapsulating layer 24 further covers a side surface of the capacitance insulating layer 216. That is, the encapsulating layer 24 extends toward the edge portion 2112, and covers the side surface of the capacitance insulating layer 216 on its extending path. As such, the contact area of the encapsulating layer 24 can be increased, thereby enhancing the encapsulation reliability of the encapsulating layer 24.

In an embodiment, the functional layer group further includes an interlayer insulating layer 212 disposed at a side of the capacitance insulating layer 216 away from the base layer 211. The encapsulating layer 24 further covers a side surface of the interlayer insulating layer 212. That is, the encapsulating layer 24 extends toward the edge portion 2112, and covers the side surface of the interlayer insulating layer 212 on its extending path. As such, the contact area of the encapsulating layer 24 can be increased, thereby enhancing the encapsulation reliability of the encapsulating layer 24.

In an embodiment, the functional layer group further includes a planarizing layer 213 disposed at a side of the interlayer insulating layer 212 away from the base layer 211. The encapsulating layer 24 further covers a side surface of the planarizing layer 213. That is, the encapsulating layer 24 extends toward the edge portion 2112, and covers the side surface of the planarizing layer 213 on its extending path. As such, the contact area of the encapsulating layer 24 can be increased, thereby enhancing the encapsulation reliability of the encapsulating layer 24.

It should be noted that the stretchable display panel 100 provided in the third aspect can include other features of the stretchable display panel 100 provided in the first aspect and/or other features of the stretchable display panel 100 provided in the second aspect, which will not be repeated in the embodiments of the present application.

In a fourth aspect, an embodiment of the present application provides a display device, including the stretchable display panel in any one of the embodiments of the first aspect, the second aspect, or the third aspect.

The display device can be a smart wearable display device, a laptop computer, a mobile phone, a wireless device, a personal digital assistant (PDA), a handheld or portable computer, a GPS receiver or navigator, a camera, an MP4 video player, a camcorder, a game console, a watch, a clock, a calculator, a television monitor, a flat panel display, a computer monitor, a car display (e.g., an odometer display, etc.), a navigator, a cockpit controller and/or display, a display of a camera view (e.g., a display of a rearview camera in a vehicle), an electronic photo, an electronic billboard or sign, a projector, etc.

According to the display device provided in the embodiments of the present application, on the one hand, the extending tendency of cracks toward the light-emitting unit can be mitigated; on the other hand, the contact area of the encapsulating layer can be increased, thereby enhancing the overall encapsulation reliability and further increasing the service life of the display device.

Unless explicitly using a limiting term such as "only", "consisting of', etc., in the case of using "including", "having", and "comprising", another component can be added. Unless mentioned otherwise, a term in a singular form can include a plural form and should not be understood as being one in quantity.

## Claims

1. A stretchable display panel, **characterized by** comprising:
a substrate (1); and
a plurality of pixel islands (2) spaced from each other and disposed on the substrate (1), each of the plurality of pixel islands (2) having a light-emitting area (2a) and a non-light-emitting area (2b) adjacent to the light-emitting area (2a), each of the plurality of pixel islands (2) comprising:
a driving layer group (21) disposed on the substrate (1);
a pixel-defining structure (22) disposed on the driving layer group (21), the pixel-defining structure (22) defining a pixel opening located in the light-emitting area (2a), at least one groove (25) being located in the non-light-emitting area (2b) and disposed at a side of the pixel-defining structure (22) away from the driving layer group (21), the at least one groove (25) extending through the pixel-defining structure (22) and a part of the driving layer group (21) along a thickness direction of the substrate (1);
a light-emitting unit (23) disposed in the pixel opening; and
an encapsulating layer (24) covering a surface of the light-emitting unit (23) away from the substrate (1) and a surface of the at least one groove (25).

2. The stretchable display panel according to claim 1, wherein the driving layer group (21) comprises an inorganic film layer and an organic film layer, and the inorganic film layer is disposed between the substrate (1) and the organic film layer;
the groove (25) at least extends through the organic film layer to expose a part of the inorganic film layer,
the encapsulating layer (24) covers an exposed surface of the inorganic film layer;
optionally, the groove (25) extends through a part of the inorganic film layer;
optionally, the driving layer group (21) comprises an interlayer insulating layer (212) and a planarizing layer (213), the interlayer insulating layer (212) is located between the substrate (1) and the planarizing layer (213), the interlayer insulating layer (212) is the inorganic film layer, the planarizing layer (213) is the organic film layer, and the groove (25) extends through the planarizing layer (213) and a part of the interlayer insulating layer (212).

3. The stretchable display panel according to claim 2, further comprising a connecting wire (3), wherein adjacent pixel islands (2) are connected through the connecting wire (3); the driving layer group (21) comprises a connecting line (214), and the connecting line (214) is electrically connected to the connecting wire (3);
optionally, the connecting line (214) comprises a first connecting line portion (2141) and a second connecting line portion (2142); one end of the second connecting line portion (2142) is electrically connected to the first connecting line portion (2141), and another end of the second connecting line portion (2142) is electrically connected to the connecting wire (3); the first connecting line portion (2141) and the second connecting line portion (2142) are disposed in different layers;
optionally, the first connecting line portion (2141) is located between the interlayer insulating layer (212) and the planarizing layer (213);
optionally, the driving layer group (21) further comprises a gate electrode insulating layer (215) and a capacitance insulating layer (216), the gate electrode insulating layer (215) and the capacitance insulating layer (216) are located between the substrate (1) and the interlayer insulating layer (212), and the gate electrode insulating layer (215) is located between the substrate (1) and the capacitance insulating layer (216); and
the second connecting line portion (2142) is located between the gate electrode insulating layer (215) and the capacitance insulating layer (216);
optionally, the driving layer group (21) further comprises a gate electrode (219), the gate electrode (219) is located between the gate electrode insulating layer (215) and the capacitance insulating layer (216), and the second connecting line portion (2142) and the gate electrode (219) are disposed in a same layer;
optionally, an orthographic projection of the second connecting line portion (2142) on the substrate (1) overlaps with an orthographic projection of the groove (25) on the substrate (1);
optionally, the first connecting line portion (2141) is electrically connected to the second connecting line portion (2142) through a first through-hole structure (2144);
optionally, an orthographic projection of the first connecting line portion (2141) on the substrate (1) overlaps with an orthographic projection of the second connecting line portion (2142) on the substrate (1);
optionally, the connecting line (214) further comprises a third connecting line portion (2143), the second connecting line portion (2142) is electrically connected to the connecting wire (3) through the third connecting line portion (2143); the third connecting line portion (2143) and the second connecting line portion (2142) are disposed in different layers;
optionally, the third connecting line portion (2143) and the first connecting line portion (2141) are disposed in a same layer;
optionally, the third connecting line portion (2143) is electrically connected to the second connecting line portion through a second through-hole structure (2145);
optionally, an orthographic projection of the third connecting line portion (2143) on the substrate (1) overlaps with an orthographic projection of the second connecting line portion (2142) on the substrate (1).

4. The stretchable display panel according to any one of claims 1 to 3, wherein an orthographic projection of the encapsulating layer (24) on the pixel-defining structure (22) covers the groove (25);
optionally, the at least one groove (25) is a plurality of grooves (25) disposed in the pixel-defining structure (22), the plurality of grooves (25) are spaced from each other and located in the non-light-emitting area (2b), and the encapsulating layer (24) covers surfaces of the plurality of grooves (25);
optionally, the non-light-emitting area (2b) surrounds a periphery of the light-emitting area (2a), and the groove (25) surrounds the periphery of the light-emitting area (2a);
optionally, an orthographic projection of the groove (25) on the substrate (1) is shaped as a closed ring.

5. The stretchable display panel according to any one of claims 1 to 4, wherein, the groove (25) comprises a plurality of first groove segments (251), and the plurality of first groove segments (251) are spaced from each other and together surround the periphery of the light-emitting area (2a);
optionally, in two adjacent grooves (25), each groove (25) comprises a plurality of first groove segments (251), and a gap exists between two adjacent first groove segments (251) in the each groove (25); in the two adjacent grooves (25), the gap of one groove (25) is located corresponding to one first groove segment (251) of another groove (25);
optionally, the groove (25) comprises a first main groove (252) and a plurality of first sub-grooves (253); an orthographic projection of the first main groove (252) on the substrate (1) is shaped as a closed ring; the first main groove (252) surrounds the periphery of the light-emitting area (2a), and the plurality of first sub-grooves (253) are spaced from each other and together surround the periphery of the light-emitting area (2a); and an orthographic projection of the plurality of first sub-grooves (253) on the substrate (1) overlaps with the orthographic projection of the first main groove (252) on the substrate (1);
optionally, the first sub-groove (253) comprises a first end (253a) and a second end (253b) opposite to the first end (253a), the first end (253a) is located at a side of the first main groove (252) adjacent to the light-emitting area (2a), and the second end (253b) is located at a side of the first main groove (252) away from the light-emitting area (2a);
optionally, a dimension of the orthographic projection of the groove on the substrate (1) along a first direction is a first width W₁, a distance between two adjacent grooves (25) is a first spacing L₁, and the first width W₁ is greater than or equal to the first spacing L₁;
the first direction is perpendicular to the thickness direction of the substrate (1) and perpendicular to a length direction of the orthographic projection of the groove (25) on the substrate (1).

6. The stretchable display panel according to any one of claims 1 to 5, wherein the driving layer group (21) comprises a main body portion (2111) and an edge portion (2112) connected to the main body portion (2111); the pixel-defining structure (22) and the light-emitting unit (23) are both disposed on the main body portion (2111);
the pixel island (2) further comprises at least one protective structure (26) disposed on the edge portion (2112), the protective structure (26) comprises at least one concave portion (26a), and the encapsulating layer (24) further covers a surface of the concave portion (26a);
optionally, along the thickness direction of the substrate (1), a size of the main body portion (2111) is greater than a size of the edge portion (2112);
optionally, the encapsulating layer (24) further covers a side surface of the pixel-defining structure (22) and a side surface of the main body portion (2111);
optionally, the edge portion (2112) surrounds a periphery of the main body portion (2111), and the protective structure (26) surrounds the periphery of the main body portion (2111).

7. The stretchable display panel according to claim 6 wherein, the at least one protective structure (26) is a plurality of protective structures (26) spaced from each other and disposed on the edge portion (2112), and the encapsulating layer (24) covers the concave portion (26a) of each protective structure (26);
optionally, in two adjacent protective structures (26), one protective structure (26) surrounds the periphery of the main body portion (2111), and another protective structure (26) surrounds a periphery of the one protective structure (26);
optionally, the protective structure (26) comprises a plurality of sub-structures (26b), and the plurality of sub-structures (26b) are spaced from each other and together surround the periphery of the main body portion (2111);
optionally, in two adjacent protective structures (26), each protective structure (26) comprises a plurality of sub-structures (26b), and a gap exists between two adjacent sub-structures (26b) in the each protective structure (26); in the two adjacent protective structures (26), the gap of one protective structure (26) is located corresponding to one sub-structure (26b) of another protective structure (26);
optionally, a dimension of an orthographic projection of the protective structure (26) on the substrate (1) along a first direction is a second width W₂, a distance between two adjacent protective structures (26) is a second spacing L₂, and the second width W₂ is greater than or equal to the second spacing L₂;
the first direction is perpendicular to the thickness direction of the substrate (1) and perpendicular to a length direction of the protective structure (26).

8. The stretchable display panel according to claim 6 or 7, wherein the protective structure (26) comprises a plurality of concave portions (26a), and the encapsulating layer (24) covers surfaces of the plurality of concave portions (26a);
optionally, the protective structure (26) comprises two concave portions (26a), and openings of the two concave portions (26a) are opposite to each other;
optionally, the protective structure (26) comprises a first sub-portion (261) and a second sub-portion (262) which are sequentially stacked on the edge portion (2112), and two opposite ends of the second sub-portion (262) along a first direction respectively protrude from side surfaces of the first sub-portion (261); the first direction is perpendicular to the thickness direction of the substrate (1);
the first sub-portion (261), a protruding portion of the second sub-portion (262), and the edge portion (2112) together define the concave portion (26a);
optionally, the protective structure (26) comprises a third sub-portion (263), a first sub-portion (261), and a second sub-portion (262) which are sequentially stacked on the edge portion (2112); two opposite ends of the third sub-portion (263) along a first direction respectively protrude from side surfaces of the first sub-portion (261); two opposite ends of the second sub-portion (262) along the first direction respectively protrude from the side surfaces of the first sub-portion (261); the first direction is perpendicular to the thickness direction of the substrate (1);
a protruding portion of the third sub-portion (263), the first sub-portion (261), and the protruding portion of the second sub-portion (262) together define the concave portion (26a);
optionally, the third sub-portion (263) and the second sub-portion (262) are made of a same material;
optionally, the third sub-portion (263) and the first sub-portion (261) are made of different materials;
optionally, a material of the third sub-portion (263) comprises titanium, and a material of the first sub-portion (261) comprises aluminum.

9. The stretchable display panel according to any one of claims 1 to 8, wherein
the pixel island (2) further comprises:
an encapsulation auxiliary structure (27) disposed on the driving layer group (21) and located in the non-light-emitting area (2b), at least one slot (271) being disposed at a side of the encapsulation auxiliary structure (27) away from the driving layer group (21), the encapsulation auxiliary structure (27) comprising an inorganic material;
the encapsulating layer (24) further covers a surface of the light-emitting unit (23) away from the substrate (1) and a surface of the slot (271).

10. The display panel according to claim 9, wherein the at least one slot (271) is a plurality of slots (271) spaced from each other and disposed at the side of the encapsulation auxiliary structure (27) away from the driving layer group (21), and the encapsulating layer (24) covers surfaces of the plurality of slots (271);
optionally, an orthographic projection of the encapsulating layer (24) on the substrate (1) covers an orthographic projection of the slot (271) on the substrate (1);
optionally, the encapsulation auxiliary structure (27) surrounds a periphery of the light-emitting area (2a), and the slot (271) surrounds the periphery of the light-emitting area (2a);
optionally, an orthographic projection of the slot (271) on the substrate (1) is shaped as a closed ring;
optionally, the slot (271) comprises a plurality of second slot segments, and the plurality of second slot segments are spaced from each other and together surround the periphery of the light-emitting area (2a);
optionally, in two adjacent slots (271), each slot (271) comprises a plurality of second slot segments, and a gap exists between two adjacent second slot segments in the each slot (271); in the two adjacent slots (271), the gap of one slot (271) is located corresponding to one second slot segment of another slot (271);
optionally, the slot (271) comprises a second main slot and a plurality of second sub-slots; an orthographic projection of the second main slot on the substrate (1) is shaped as a closed ring, and the second main slot surrounds the periphery of the light-emitting area (2a); the plurality of second sub-slots are spaced from each other and together surround the periphery of the light-emitting area (2a), and an orthographic projection of the second sub-slots on the substrate (1) overlaps with the orthographic projection of the second main slot on the substrate (1);
optionally, the second sub-slot comprises a third end and a fourth end opposite to the third end, the third end is located at a side of the second main slot adjacent to the light-emitting area (2a), and the fourth end is located at a side of the second main slot away from the light-emitting area (2a);
optionally, a dimension of an orthographic projection of the slot (271) on the substrate (1) along a first direction is a third width W₃, a distance between two adjacent slots (271) is a third spacing L₃, and the third width W₃ is greater than or equal to the third spacing L₃;
the first direction is perpendicular to a thickness direction of the substrate (1) and perpendicular to a length direction of the orthographic projection of the slot (271) on the substrate (1).

11. The stretchable display panel according to claim 9 or 10, wherein the encapsulation auxiliary structure (27) comprises at least one protrusion portion (272) disposed at a side adjacent to the driving layer group (21), and the driving layer group (21) comprises at least one recess portion (2131) disposed at a side adjacent to the encapsulation auxiliary structure (27), and the at least one protrusion portion (272) mates with the at least one recess portion (2131);
optionally, the at least one protrusion portion (272) is a plurality of protrusion portions (272) spaced from each other and disposed at the side adjacent to the driving layer group (21), the at least one recess portion (2131) is a plurality of recess portions (2131) disposed at the side adjacent to the encapsulation auxiliary structure (27), and the plurality of protrusion portions (272) mate with the plurality of recess portions (2131) in a one-to-one correspondence;
optionally, the at least one slot (271) is a plurality of slots (271) spaced from each other and disposed in the encapsulation auxiliary structure (27), an orthographic projection of one slot (271) on the driving layer group (21) overlaps with an orthographic projection of one protrusion portion (272) on the driving layer group (21);
optionally, the plurality of slots (271) and the plurality of protrusion portions (272) are in a one-to-one correspondence, an orthographic projection of each slot (271) on the driving layer group (21) overlaps with an orthographic projection of a corresponding protrusion portion (272) on the driving layer group (21);
optionally, the driving layer group (21) comprises a planarizing layer (213), and the recess portion (2131) is disposed on a surface of the planarizing layer (213) away from the substrate (1);
optionally, along a thickness direction of the substrate (1), a size of the recess portion (2131) is Hi, a size of the planarizing layer (213) is H₂, and H₁ and H₂ satisfy a relationship of H₁ ≤ 0.5H₂.

12. The stretchable display panel according to claim any one of claims 9 to 11, wherein a surface of the encapsulation auxiliary structure (27) adjacent to the driving layer group (21) is a flat surface;
a surface of the pixel-defining structure (22) adjacent to the driving layer group (21) is flush with the surface of the encapsulation auxiliary structure (27) adjacent to the driving layer group (21);
optionally, the pixel-defining structure (22) is adjacent to the encapsulation auxiliary structure (27).

13. The stretchable display panel according to any one of claims 9 to 12, wherein the driving layer group (21) comprises a main body portion (2111) and an edge portion (2112) connected to the main body portion (2111); the light-emitting unit (23) is disposed on the main body portion (2111);
the pixel island (2) further comprises at least one protective structure (26) disposed on the edge portion (2112), the protective structure (26) comprises at least one concave portion (26a), and the encapsulating layer (24) further covers a surface of the concave portion (26a);
optionally, along a thickness direction of the substrate (1), a size of the main body portion (2111) is greater than a size of the edge portion (2112);
optionally, the stretchable display panel comprises a pixel-defining structure (22), the pixel-defining structure (22) is disposed on the main body portion (2111), the pixel-defining structure (22) defines a pixel opening located in the light-emitting area (2a), the light-emitting unit (23) is disposed in the pixel opening, and the encapsulating layer (24) further covers a side surface of the pixel-defining structure (22) and a side surface of the main body portion (2111);
optionally, the edge portion (2112) surrounds a periphery of the main body portion (2111), and the protective structure (26) surrounds the periphery of the main body portion (2111).

14. The stretchable display panel according to claim 13, wherein, the at least one protective structure (26) is a plurality of protective structures (26) spaced from each other and disposed on the edge portion (2112), and the encapsulating layer (24) covers the concave portion (26a) of each protective structure (26);
optionally, in two adjacent protective structures (26), one protective structure (26) surrounds the periphery of the main body portion (2111), and another protective structure (26) surrounds a periphery of the one protective structure (26);
optionally, the protective structure (26) comprises a plurality of sub-structures (26b), and the plurality of sub-structures (26b) are spaced from each other and together surround the periphery of the main body portion (2111);
optionally, in two adjacent protective structures (26), each protective structure (26) comprises a plurality of sub-structures (26b), and a gap exists between two adjacent sub-structures (26b) in the each protective structure (26); in the two adjacent protective structures (26), the gap of one protective structure (26) is located corresponding to one sub-structure (26b) of another protective structure (26);
optionally, a dimension of an orthographic projection of the protective structure (26) on the substrate (1) along a first direction is a second width W₂, a distance between two adjacent protective structures (26) is a second spacing L₂, and the second width W₂ is greater than or equal to the second spacing L₂;
the first direction is perpendicular to a thickness direction of the substrate (1) and perpendicular to a length direction of the protective structure (26).

15. The stretchable display panel according to claim 13 or 14, wherein the protective structure (26) comprises a plurality of concave portions (26a), and the encapsulating layer (24) covers surfaces of the plurality of concave portions (26a);
optionally, the protective structure (26) comprises two concave portions (26a), and openings of the two concave portions (26a) are opposite to each other;
optionally, the protective structure (26) comprises a first sub-portion (261) and a second sub-portion (262) which are sequentially stacked on the edge portion (2112), and two opposite ends of the second sub-portion (262) along a first direction respectively protrude from side surfaces of the first sub-portion (261); the first direction is perpendicular to a thickness direction of the substrate (1);
the first sub-portion (261), a protruding portion of the second sub-portion (262), and the edge portion (2112) together define the concave portion (26a);
optionally, the protective structure (26) comprises a third sub-portion (263), a first sub-portion (261), and a second sub-portion (262) which are sequentially stacked on the edge portion (2112); two opposite ends of the third sub-portion (263) along a first direction respectively protrude from side surfaces of the first sub-portion (261); two opposite ends of the second sub-portion (262) along the first direction respectively protrude from side surfaces of the first sub-portion (261); the first direction is perpendicular to a thickness direction of the substrate (1);
a protruding portion of the third sub-portion (263), the first sub-portion (261), and a protruding portion of the second sub-portion (262) together define the concave portion (26a);
optionally, the third sub-portion (263) and the second sub-portion (262) are made of a same material;
optionally, the third sub-portion (263) and the first sub-portion (261) are made of different materials;
optionally, a material of the third sub-portion (263) comprises titanium, and a material of the first sub-portion (261) comprises aluminum.
